# EUROPÄISCHE PATENTSCHRIFT

(11) **EP 0 499 675 B1**
(45) Veröffentlichungstag und Bekanntmachung des Hinweises auf die Patenterteilung: **23.09.1998**
(21) Anmeldenummer: 91102583.1
(22) Anmeldetag: 22.02.1991
(51) Int. Cl.: H05K 7/14

(54) **Flexibles Automatisierungssystem**
Flexible automation system
Automate flexible

(43) Veröffentlichungstag der Anmeldung: 26.08.1992
(73) Patentinhaber: SIEMENS AKTIENGESELLSCHAFT, 80333 München (DE)
(72) Erfinder: Donhauser, Peter, Dipl.-Ing. (FH), W-8450 Amberg (DE); Gmeiner, Richard, Dipl.-Ing. (FH), W-8450 Amberg (DE)

(56) Entgegenhaltungen:
- DE-A- 3 603 750
- DE-A- 3 629 566
- DE-A- 3 932 005
- US-A- 4 790 762

## Beschreibung

Die Erfindung betrifft ein erweiterbares Automatisierungssystem.

Derzeit am Markt befindliche Automatisierungssysteme sind in zwei Gruppen aufteilbar, nämlich in modular aufgebaute Automatisierungsgeräte und in allein betriebsfähige Automatisierungsgeräte. Letztere können auch durch das Anschließen von Zusatzgeräten erweitert werden. Beide Arten von Automatisierungsgeräten haben jedoch gruppenspezifische Nachteile.

Allein betriebsfähige Automatisierungsgeräte, sogenannte Kompaktgeräte, sind zwar relativ preiswert bei der Erstinstallation, stoßen bei einer späteren Erhöhung des Automatisierungsgrades jedoch schnell an ihre Grenzen, und zwar sowohl bezüglich der Erweiterbarkeit als auch bezüglich der Rechenleistung des Kompaktgeräts. Bei einer späteren Erweiterung muß daher oftmals das komplette Automatisierungsgerät gegen ein modular aufgebautes Automatisierungsgerät ausgetauscht werden.

Modular aufgebaute Automatisierungssysteme, wie sie beispielsweise aus der DE-OS 36 03 750 bekannt sind, vermeiden zwar diese Nachteile, ihre Minimalkonfiguration, die aus einer Zentraleinheit und wenigen Erweiterungsmodulen besteht, ist jedoch häufig erheblich teurer als ein Kompaktgerät.

Aufgabe der vorliegenden Erfindung ist es, ein Automatisierungssystem zur Verfügung zu stellen, das sowohl für kleine Automatisierungsaufgaben als auch für größere Automatisierungsaufgaben geeignet ist und das bei einer späteren Erweiterung jederzeit an geänderte Anforderungen anpaßbar ist.

Die Aufgabe wird durch ein Automatisierungssystem gemäß Anspruch 1 bzw. durch ein Verfahren zum Erweitern eines Automatisierungssystems gemäß Anspruch 3 gelöst.

Durch das Verfahren gemäß Anspruch 3 ist es möglich, zunächst nur ein Kompaktgerät einzusetzen, das sehr preiswert ist. Bei einer späteren Erweiterung des Automatisierungsgeräts werden Module des modular aufgebauten Autamatisierungeräts an das Kompaktgerätangeschlossen. Falls beispielsweise für die dritte Erweiterung eine höhere Rechenleistung benötigt wird, wird dann das Kompaktgerät gegen die Zentraleinheit des modular aufgebauten Automatisierungsgeräts ausgetauscht.

Wenn die Erweiterungsmodule mit dem allein betriebsfähigen Automatisierungsgerät über ein Schnittstellenmodul verbunden sind, ist es möglich, das allein betriebsfähige Automatisierungsgerät und das modular aufgebaute Automatisierungsgerät unabhängig voneinander zu entwicklen, da die Schnittstellenanpassung durch das Schnittstellenmodul erfolgt.

Wenn das Schnittstellenmodul Anschlüsse zur Energieversorgung des Schnittstellenmoduls und der Erweiterungsmodule aufweist, kann das allein betriebsfähige Automatisierungsgerät besonders klein und noch kostengünstiger hergestellt werden, da dann die Stromversorgungseinrichtung des Kompaktgeräts nur so groß ausgelegt sein muß, daß sie das Kompaktgerät selbst mit Strom versorgen kann.

Wenn das Schnittstellenmodul eine mit der Schnittstelle korrespondierende Gegenschnittstelle, z.B. eine Buchse aufweist, die über ein mehradriges, flexibles Kabel, vorzugsweise ein Flachbandkabel, mit dem Schnittstellenmodul verbunden ist, kann die Schnittstelle des Kompaktgeräts starr am Kompaktgerät befestigt sein. Dies ermöglicht eine besonders einfache Konstruktion der Schnittstelle und vermeidet darüber hinaus Aufbewahrungsprobleme der Schnittstelle im Stand-alone-Betrieb.

Weitere Vorteile und Einzelheiten ergeben sich aus der nachfolgenden Beschreibung eines Ausführungsbeispiels, anhand der Zeichnungen und in Verbindung mit den weiteren Unteransprüchen. Es zeigen:
- FIG 1: die Frontseite eines allein betriebsfähigen Automatisierungsgeräts,
- FIG 2: eine perspektivische Ansicht des Automatisierungsgeräts,
- FIG 3: das Schnittstellenmodul,
- FIG 4: die Frontansicht des Automatisierungsgeräts mit Erweiterungsgeräten und
- FIG 5: die Draufsicht auf das Automatisierungsgerät mit Erweiterungsgeräten.

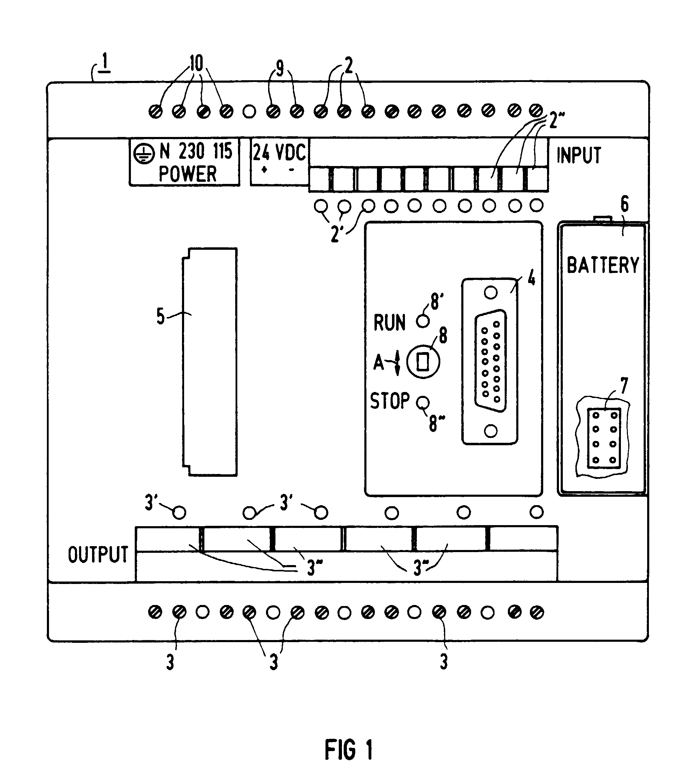

Gemäß FIG 1 weist ein Automatisierungsgerät 1 Schraubanschlüsse 2, 3 zur externen Verdrahtung von Leitungen für Eingangs- bzw. Ausgangssignale auf. Den Schraubanschlüssen 2,3 sind jeweils Leuchtdioden-Anzeigen 2', 3' zugeordnet. Weiterhin weist das Automatisierungsgerät 1 einen SUB-D-Steckanschluß 4 auf, an den ein Programmiergerät angeschlossen werden kann, sowie einen Schacht 5 zum Einstecken eines Anwendermoduls, ein Batteriefach 6 und einen mehrpoligen Stecker 7 zum Anschließen von Erweiterungsgeräten 29 über ein Schnittstellenmodul 22 auf. Mit dem Schalter 8, der in Richtung des Doppelpfeiles A schaltbar ist, kann der Anwender das Programm des Automatisierungsgeräts 1 starten bzw. stoppen. Der Schaltzustand des Geräts 1 wird über die Anzeigen 8', 8" angezeigt.

Den Leuchtdiodenanzeigen 2', 3' sind Beschriftungsfelder 2", 3" zugeordnet, so daß mit einem Blick erkennbar ist, welche Bedeutung welchem Anschluß 2, 3 bzw. der zugeordneten Leuchtdiodenanzeige 2', 3' zukommt. Wie aus FIG 1 weiterhin ersichtlich ist, weist das Automatisierungsgerät 1 ein Schraubanschlußpaar 9 auf, über das z.B. nicht dargestellte Signalgeber mit einer Gleichspannung von 24 V vorsorgbar sind. Das Automatisierungsgerät 1 selbst ist über das Schraubanschlußquartett 10 an ein Wechselspannungsnetz von 115 bzw. 230 V anschließbar.

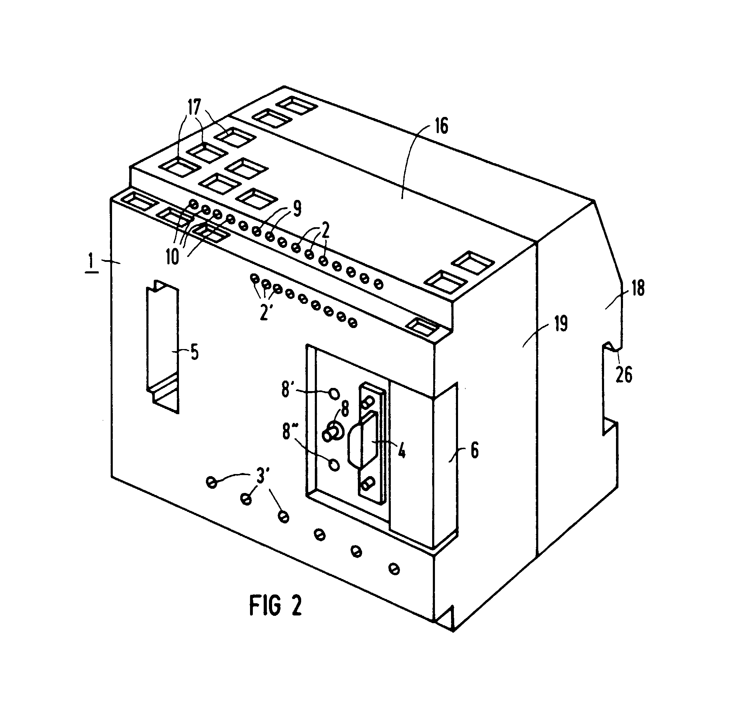

Das - allein betriebsfähige - Automatisierungsgerät 1 ist gemäß FIG 2 mit dem Vorsprung 26 an einer nicht dargestellten Norm-Hutschiene einhängbar. Nach dem Verschwenken des Geräts 1 verrastet ein nicht dargestellter, federbelasteter Riegel mit der Hutschiene, so daß das Gerät 1 mit der Hutschiene fest, aber lösbar verbunden ist.

FIG 2 zeigt ferner, daß das Automatisierungsgerät 1 auf der Oberseite 16 (sowie nicht sichtbar auch auf der Unterseite) Lüftungsgitter 17 zum Abführen der im Automatisierungsgerät 1 entstehenden Verlustwärme aufweist sowie daß die Ummantelung des Automatisierungsgeräts 1 aus einem Unterteil 18 und einer Haube 19 besteht.

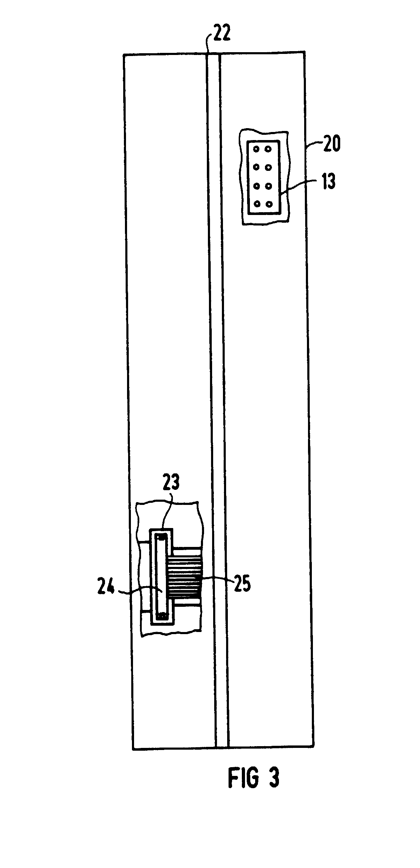

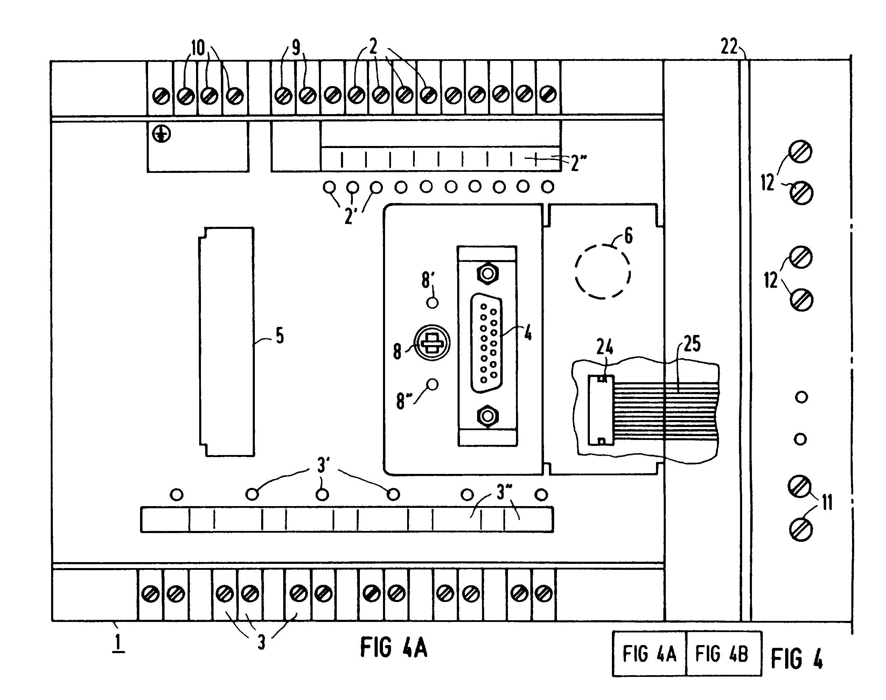

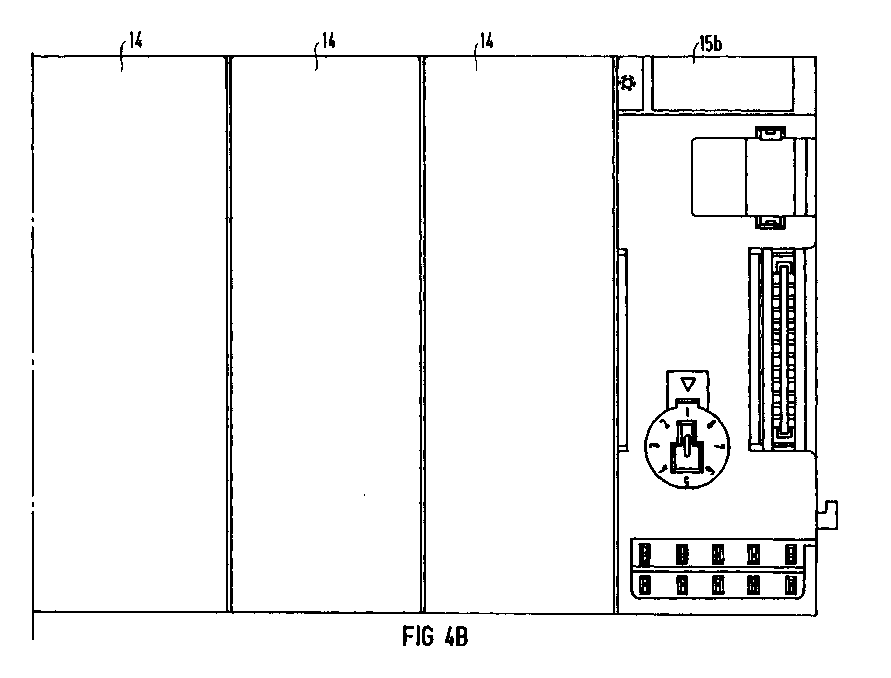

Gemäß FIG 3 weist das Schnittstellenmodul 22 eine Tasche 23 auf, in der die Steckerbuchse 24 vor dem Verbinden mit dem Stecker 7 des Automatisierungsgeräts 1 gehalten ist. Die Buchse 24 ist über das Flachbandkabel 25 mit einer (in FIG 4 nicht dargestellten) Leiterplatte des Schnittstellenmoduls 22 verbunden. Weiterhin weist das Schnittstellenmodul 22 einen mehrpoligen Stecker 13 auf, der ebenfalls mit der Leiterplatte des Schnittstellenmoduls 22 verbunden ist. Das Schnittstellenmodul 22 ist ebenso wie das Automatisierungsgerät 1 auf eine Tragschiene, z.B. eine Norm-Hutschiene, aufschnappbar. Besonders leicht zugänglich ist der Stecker 13, wenn er in der Seitenwand 20 des Schnittstellenmoduls 22 angeordnet ist.

Zum Anschließen von Erweiterungsgeräten 14 an das Automatisierungsgerät 1 wird das Schnittstellenmodul 22 neben dem Automatisierungsgerät 1 auf die oben erwähnte Tragschiene aufgeschnappt, die Buchse 24 aus der Tasche 23 genommen und mit dem Steckanschluß 7 des Automatisierungsgeräts 1 verbunden. Die Erweiterungsgeräte 14 selbst sind über eine Steckverbindung mit dem Stecker 13 des Schnittstellenmoduls 22 verbindbar. Die Erweiterungsgeräte 14 sind dabei die Module eines modular aufgebauten Automatisierungsgeräts, wie es beispielsweise von der Siemens AG unter der Typenbezeichnung SIMATIC S5-100 angeboten wird und u.a. in der DE-OS 36 03 750 beschrieben ist. Dieses Automatisierungsgerät besteht aus einer Zentraleinheit und Erweiterungsmodulen. Bei der SIMATIC 55-100 werden einzelne Baugruppenträger 15a, 15b nebeneinander auf eine Norm-Hutschiene aufgeschnappt und über ein Flachbandkabel jeweils mit den Nachbarn verbunden.

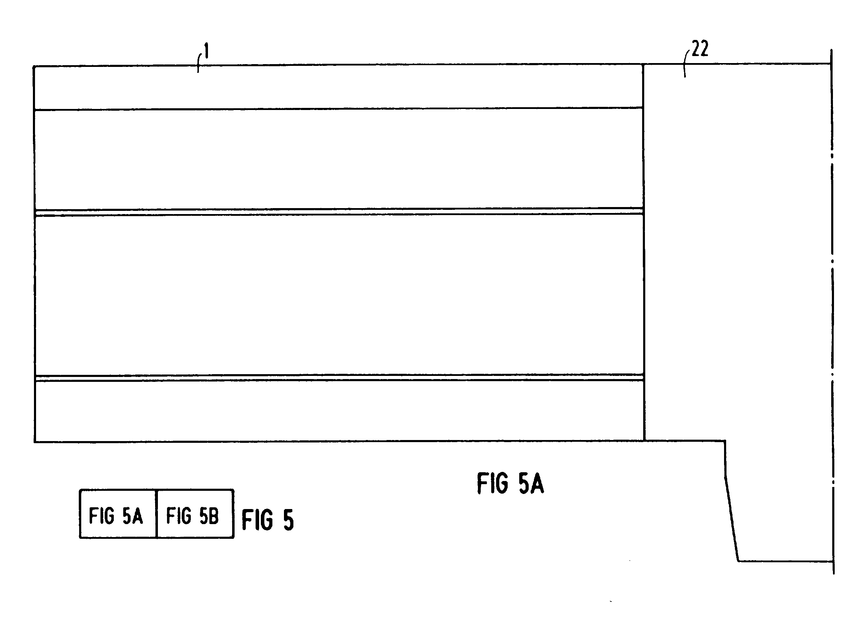

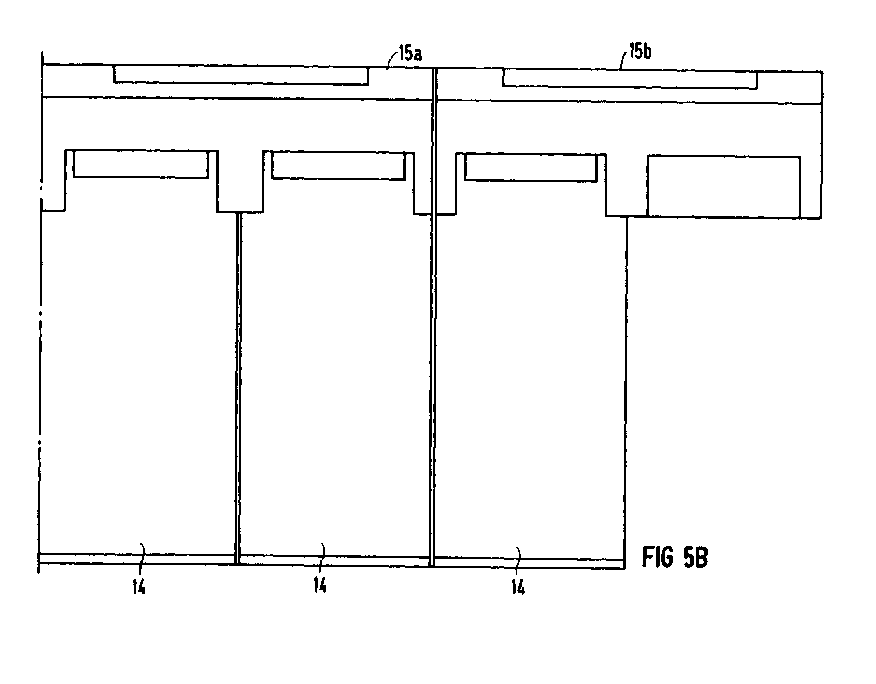

Wie die Figuren 4 und 5 zeigen, wobei FIG 5 sehr schematisch ausgeführt ist, werden zum Erweitern des Automatisierungsgeräts 1 das Schnittstellenmodul 22 rechts neben das Automatisierungsgerät 1 und die modularen Baugruppenträger 15a, 15b rechts neben das Schnittstellenmodul 22 auf eine nicht dargestellte Hutschiene aufgeschnappt. Die Baugruppenträger 15a, 15b werden über eine Steckverbindung und ein Flachbandkabel miteinander verbunden. Der Baugruppenträger 15a, der an das Schnittstellenmodul 22 angrenzt, wird mit der Steckverbindung 13 des Schnittstellenmoduls 22 verbunden. Die Buchse 24 des Schnittstellenmoduls 22 wird mit der Steckverbindung 7 des Automatisierungsgeräts 1 verbunden. Dadurch ist es möglich, daß das Automatisierungsgerät 1 und die in die Baugruppenträger 15a, 15b eingeschwenkten Baugruppen 14 miteinander Daten austauschen.

Dadurch, daß als Erweiterungsmodule die Baugruppen 14 eines bereits am Markt befindlichen, modular aufgebauten Automatisierungssystems verwendet werden, fallen für die Erweiterungsmodule 14 keine Entwicklungskosten an. Dadurch, daß das Automatisierungsgerät 1 bereits allein betriebsfähig ist, bleibt jedoch auch der Minimalausbau des neuen Automatisierungssystems kostengünstig. Um die Kosten für das Automatisierungsgerät 1 minimal zu halten, weist das Schnittstellenmodul 22 Anschlüsse 11 und 12 auf, über die das Schnittstellenmodul 22 und die Erweiterungsmodule 14 mit Strom versorgt werden. Die Anschlüsse 11 stellenanalog zu den Anschlüssen 9 des Automatisierungsgeräts 1 - wieder eine 24 V-Gleichspannungsquelle und die Anschlüsse 12 Netzanschlüsse für 230 bzw. 115 Volt dar.

Durch die Summe dieser Maßnahmen ergibt sich eine bisher nicht erreichte Flexibilität und Kosteneffizienz. Bei kleinen Automatisierungsaufgaben kann ein Anwender beispielsweise nur das Kompaktgerät 1 verwenden. Wenn der Anwender seinen Automatisierungsumfang später erweitern will, kann er, was für ihn sehr kostengünstig ist, über das Schnittstellenmodul 22 die Erweiterungsmodule 14 an das Kompaktgerät 1 anschließen. Wenn er später nochmals den Automatisierungsumfang erweitern will, kann es geschehen, daß die Kapazität des Kompaktgeräts 1 zu gering wird. In diesem Fall kann der Anwender das Kompaktgerät 1 nebst Schnittstellenmodul 22 gegen die Zentraleinheit des modularen Automatisierungsgeräts austauschen und ist dann aufgrund der höheren Rechenleistung der Zentraleinheit in der Lage, weitere Erweiterungsmodule 14 anzuschließen. Die bisher verwendeten Erweiterungsmodule 14 können jedoch weiterhin verwendet werden.

Abschließend sei darauf hingewiesen, daß es bei entsprechender Ausgestaltung der Schnittstelle 7 des Automatisierungsgeräts 1 selbstverständlich auch möglich ist, die Erweiterungsgeräte 14 direkt, also ohne Schnittstellenmodul 22 an das Automatisierungsgerät 1 anzuschließen. Auch in diesem Falle erfolgt vorteilhafter Weise die Verbindung über ein mehradriges, flexibles Kabel, z.B. ein Flachbandkabel.

## Patentansprüche

1. Automatisierungssystem bestehend zumindest aus
- einem allein betriebsfähigen Automatisierungsgerät (1) mit einer Schnittstelle (7) zum Anschließen von Erweiterungsgeräten
- zumindest einem Erweiterungsmodul (14) eines modularen Automatisierungsgerätes und einem Schnittstellenmodul (22) mit einer Schnittstellenanpassung,
- wobei das Erweiterungsmodul (14) über das Schnittstellenmodul (22) an das allein betriebsfähige Automatisierungsgerät (1) anschließbar ist und
- wobei das Schnittstellenmodul (22)
- eine zur der Schnittstelle (7) des Automatisierungsgerätes (1) kompätible Schnittstelle (24) und
- eine zur der Schnittstelle der Erweiterungsmodule (14) kompatible Schnittstelle (13)
aufweist.

2. Automatisierungssystem nach Anspruch 1, **dadurch gekennzeichnet,** daß das Schnittstellenmodul (22) Anschlüsse (11, 12) zur Energieversorgung des Schnittstellenmoduls (22) und der Erweiterungsmodule (14) aufweist.

3. Verfahren zum Erweitern eines Automatisierungssystems,
- wobei in einem ersten Schritt ein allein betriebsfähiges Automatisierungsgerät (1) eingesetzt wird,
- wobei in einem zweiten Schritt Erweiterungsmodule (14) eines modular aufgebauten Automatisierungsgerätes an das allein betriebsfähige Automatisierungsgerät (1) angeschlossen werden, wobei zum Anschließen der Erweiterungsmodule (14) des modular aufgebauten Automatisierungsgerätes an das allein betriebsfähige Automatisierungsgerät (1) ein Schnittstellenmodul (22) mit einer Schnittstellenanpassung vorgesehen ist, wobei das Schnittstellenmodul (22)
- eine zur einer Schnittstelle (7) des allein betriebsfähigen Automatisierungsgerätes (1) kompatible Schnittstelle (24) und
- eine zur einer Schnittstelle der Erweiterungsmodule (14) kompatible Schnittstelle (13) aufweist, und
- wobei in einem dritten Schritt das allein betriebsfähige Automatisierungsgerät (1) gegen eine Zentraleinheit des modular aufgebauten Automatisierungsgerätes ausgetauscht wird.

## Claims

1. Automation system consisting of at least
- one programmable controller (1) that is capable of stand-alone operation and has an interface (7) for the purpose of connecting extension units,
- at least one extension module (14) of a modular programmable controller and an interface module (22) having interface adaptation,
- wherein the extension module (14) can be connected to the programmable controller (1) that is capable of stand-alone operation by way of the interface module (22), and
- wherein the interface module (22) has
- an interface (24) which is compatible with the interface (7) of the programmable controller (1), and
- an interface (13) which is compatible with the interface of the extension modules (14).

2. Automation system according to claim 1, characterised in that the interface module (22) has connections (11, 12) for the purpose of supplying power to the interface module (22) and the extension modules (14).

3. Method for extending an automation system,
- wherein a programmable controller (1) that is capable of stand-alone operation is used in a first step,
- wherein in a second step extension modules (14) of a programmable controller that is set up in a modular manner are connected to the programmable controller (1) that is capable of stand-alone operation, wherein an interface module (22) that has interface adaptation is provided for the purpose of connecting the extension modules (14) of the programmable controller that is set up in a modular manner to the programmable controller (1) that is capable of stand-alone operation,
wherein the interface module (22) has
- an interface (24) which is compatible with an interface (7) of the programmable controller (1) that is capable of stand-alone operation, and
- an interface (13) which is compatible with an interface of the extension modules (14), and
- wherein in a third step the programmable controller (1) that is capable of stand-alone operation is exchanged for a central processing unit of the programmable controller that is set up in a modular manner.

## Revendications

1. Système d'automatisation constitué d'au moins
- un appareil (1) d'automatisation pouvant fonctionner seul et comportant une interface (7) pour le raccordement d'appareils d'agrandissement,
- au moins un module (14) d'agrandissement d'un appareil d'automatisation modulaire et un module (22) d'interface à dispositif d'adaptation d'interface,
- le module (14) d'agrandissement pouvant être raccordé à l'appareil (1) d'automatisation pouvant fonctionner seul par l'intermédiaire du module (22) d'interface et
- le module (22) d'interface comportant
- une interface (24) compatible avec l'interface (7) de l'appareil (1) d'automatisation et
- une interface (13) compatible avec l'interface des modules (14) d'agrandissement.

2. Système d'automatisation suivant la revendication 1 caractérisé en ce que le module (22) d'interface comporte des bornes (11) et (12) pour l'alimentation en courant du module (22) d'interface et des modules (14) d'agrandissement.

3. Procédé pour agrandir un système d'automatisation,
- un appareil (1) d'automatisation pouvant fonctionner seul étant utilisé à une première étape,
- des modules (14) d'agrandissement d'un appareil d'automatisation à structure modulaire étant, à une deuxième étape, raccordés à l'appareil (1) d'automatisation pouvant fonctionner seul,
- un module (22) d'interface à dispositif d'adaptation d'interface étant prévu pour le raccordement des modules (14) d'agrandissement de l'appareil d'automatisation à structure modulaire à l'appareil (1) d'automatisation pouvant fonctionner seul, le module (22) d'interface comportant,
- une interface (24) compatible avec l'interface (7) de l'appareil (1) d'automatisation pouvant fonctionner seul et
- une interface (13) compatible avec une interface des modules (14) d'agrandissement et
- l'appareil (1) d'automatisation qui peut fonctionner seul pouvant à une troisième étape, être remplacé par une unité centrale de l'appareil d'automatisation à structure modulaire.
